(19)

Europäisches
Patentamt
European
Patent Office
Office européen
des brevets

(11) EP 2 326 056 A1

(12) EUROPEAN PATENT APPLICATION
published in accordance with Art. 153(4) EPC

(43) Date of publication:
25.05.2011 Bulletin 2011/21

(51) Int Cl.:
H04L 27/36 (2006.01)   H04J 11/00 (2006.01)
H04W 8/22 (2009.01)    H04W 28/18 (2009.01)

(21) Application number: 09812920.8

(22) Date of filing: 11.09.2009

(86) International application number:
PCT/JP2009/004544

(87) International publication number:
WO 2010/029771 (18.03.2010 Gazette 2010/11)

(84) Designated Contracting States:
AT BE BG CH CY CZ DE DK EE ES FI FR GB GR
HR HU IE IS IT LI LT LU LV MC MK MT NL NO PL
PT RO SE SI SK SM TR
Designated Extension States:
AL BA RS

(30) Priority: 12.09.2008 JP 2008234891

(71) Applicant: Sharp Kabushiki Kaisha
Osaka-shi, Osaka 545-8522 (JP)

(72) Inventors:
• NAKANO, Hiroshi
  Osaka 545-8522 (JP)
• YOKOMAKURA, Kazunari
  Osaka 545-8522 (JP)
• HAMAGUCHI, Yasuhiro
  Osaka 545-8522 (JP)

(74) Representative: Müller - Hoffmann & Partner
Patentanwälte
Innere Wiener Strasse 17
81667 München (DE)

(54) RADIO COMMUNICATION SYSTEM, RADIO COMMUNICATION METHOD, AND COMMUNICATION DEVICE

(57) A reception device (200a) transmits reception device state information indicating a modulation scheme with which the reception device is compatible, and a channel encoding method. Based on the reception device state information received, a transmission device determines a mapping method for a downlink signal to be transmitted to the reception device (200a). When the reception device (200a) is compatible with BICM-ID, the reception device (200a) transmits reception device state information indicating that the reception device (200a) is compatible with the BICM-ID. Accordingly, the backward compatibility with a communication system using gray mapping can be maintained, and the BICM-ID can be applied.

FIG. 1

**Description**

TECHNICAL FIELD

The present invention relates to a radio communication system, a radio communication method, and a communication device. Particularly, the present invention relates to a radio communication system, a radio communication method, and a communication device for performing a modulation process based on a multilevel modulation.
Priority is claimed on Japanese Patent Application No. 2008-234891, filed September 12, 2008, the content of which is incorporated herein by reference.

BACKGROUND ART

Recently, a wideband is assigned to a wireless communication system for high-capacity transmission. However, there is a problem in that the transmission power increases in proportion to the bandwidth. To achieve communication satisfying the low reception power and a low error rate of transmission data, a reception process called a turbo principle has been developed. The turbo principle is a reception process that improves the error rate characteristics by repeating a process of applying a result of a process that enhances the quality of transmission data, which is performed by multiple processors that perform different reception processes.

Conventionally, as reception processes using the turbo principle, there are: turbo equalization technology in which an equalization process of compensating distortion due to a channel and an error correction process are sequentially performed; a demapping in which a modulation symbol, which is encoded bits mapped to a signal point, is decomposed into bits in case of multi-level modulation for transmitting multiple encoded bits by one symbol; and a BICM-ID (Bit Interleaved Coded Modulation with Iterative Decoding) in which error correction processes are sequentially performed (see, for example, Non-Patent Document 1). Multi-level modulation includes, for example, QPSK (Quadrature Phase Shift Keying), 8PSK (Octuple Phase Shift Keying), 16QAM (16-ary Quadrature Amplitude Modulation), and the like.

In cellular system communication from a mobile station device to a base station device, the mobile station device performs single-carrier transmission. The base station device performs an equalization process on a reception signal received from the mobile station device. For this reason, a turbo equalization is suited to a reception process of the base station device. In communication from the base station device to the mobile station device, however, the base station device performs multi-carrier transmission based on OFDM (Orthogonal Frequency Division Multiplexing) that requires no equalization process on the receiving side. For this reason, the BICM-ID is suited to a reception process of the mobile station device.

The reception process based on the BICM-ID assumes that transmission data having been subjected to multi-level modulation is received. In other words, on the transmitting side, multiple encoded bits are assigned to one modulation symbol as a signal point, and the modulation symbol assigned the signal point is transmitted. The modulation symbol is received on the receiving side. For this reason, determination of the transmitted signal point on the receiving side depends on likelihoods of the encoded bits included in one modulation symbol. For this reason, the degree of improvement of the likelihoods, which is obtained by error correction coding, is used again in a demapping process, and thereby the reliability of determination of the transmitted signal point can be enhanced. Then, the likelihoods of the encoded bits, which have been subjected to demapping after the reliability has been enhanced, are subjected again to an error correction decoding, and thereby the reliability can be further improved. Thus, the error rate characteristics can be improved by iterating the error correction decoding process and the demapping process.

Hereinafter, an improvement of the error rate characteristics based on the BICM-ID is explained in a case where a modulation scheme is 16QAM, and a mapping method is a set partitioning mapping.

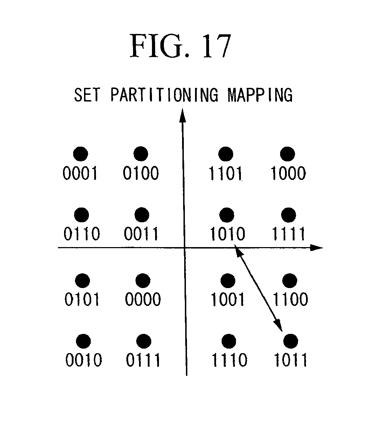

FIG. 17 illustrates signal points based on modified set partitioning mapping for 16QAM.
A horizontal axis shown in FIG. 17 denotes the amplitude of an in-phase component of a received signal. A vertical axis denotes the amplitude of an orthogonal component of a received signal. The set partitioning mapping is a mapping method determined by dividing each modulation point into a sub-set such that the minimum Euclidean distance gradually increases.

According to the BICM-ID, when there is no prior information (likelihoods of encoded bits that are obtained by an error correction decoding), all the signal points have the same probability of being transmitted. For this reason, the signal point, which is closest to a received signal point, is regarded as a signal point having the highest probability of having been transmitted. On the other hand, if the first to third bits of four bits denoting a signal point shown in FIG. 17 are recognized, the number of signal points can be limited to two. For example, if the first to third bits are recognized as 101, the number of signal points can be limited to two of 1011 and 1010. For this reason, the distance from the received signal point to 1011 and the distance from the received signal point to 1010 are calculated, and then the signal point that is closer to the received signal point is determined as having been transmitted. Thus, received bits are recognized, and thereby signal points having different bits from the recognized bits can be excluded, thereby enabling an increase in distances among signal points. Thus, if the result of the iteration process converges in the case of the BICM-ID, even if multiple bits are transmitted by one symbol based on multi-level decoding, the performance is determined based on the distance between two signal points differing from each other by only one bit. Therefore, the error rate characteristics can be improved.

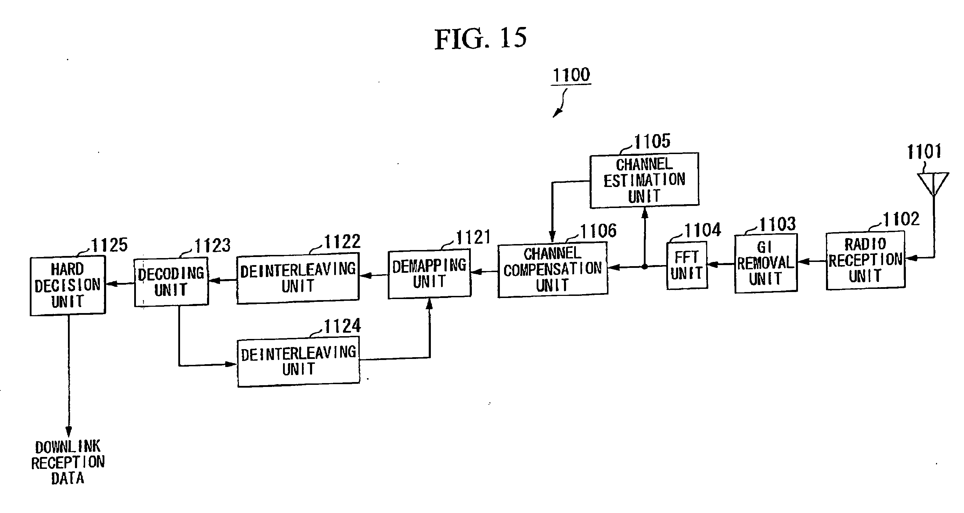

Hereinafter, a conventional communication system, to which the BICM-ID is applied, is explained.
The communication system, to which the BICM-ID is applied, includes a reception device and a transmission device. FIG. 15 is a schematic block diagram illustrating a configuration of the conventional reception device to which the BICM-ID is applied.

A reception device 1100 is a reception device that processes transmitted data having been subjected to OFDM (Orthogonal Frequency Division Multiplexing). A reception device 1100 receives a signal from an antenna 1101, and inputs the received signal to a radio reception unit 1102. The radio reception unit 1102 downconverts the received signal into a baseband signal, and then converts an analog signal, which is the baseband signal, into a digital signal. Then, a GI (Guard Interval) removal unit 1103 removes a guard interval from the received signal having been converted into the digital signal.

An FFT (Fast Fourier Transform) unit 1104 performs Fourier transform to convert the received signal, from which the guard interval has been removed, into a frequency-domain signal. From the received signal having been subjected to the Fourier transform, a channel estimation unit 1105 estimates a complex gain of a channel for each subcarrier included in the received signal. Based on the estimated complex gain of the channel for each subcarrier included in the received signal, a channel compensation unit 1106 compensates received modulation symbols on each subcarrier included in the received signal having been subjected to the Fourier transform. Then, the channel compensation unit 1106 inputs, to a demapping unit 1121, the received signal having been subjected to the compensation of the received modulation symbols.
At this time, the received signal output from the channel compensation unit 1106 includes information bits indicating information concerning received data, and encoded bits indicating an error correction code of the information bits.

The demapping unit 1121 performs a demapping process to decompose the input received signal into likelihoods of the respective encoded bits, where the likelihoods are log likelihood ratios.
A deinterleaving unit 1122 rearranges the order of the log likelihood ratios of the respective encoded bits obtained by the demapping unit 1121. Based on the log likelihood ratios of the encoded bits, the order of which has been rearranged, a decoding unit 1123 performs an error correction decoding, and calculates log likelihood ratios of the information bits and log likelihood ratios of the encoded bits. At this time, the log likelihood ratios of the encoded bits, which are output from the decoding unit 1123, includes the reliability of the received signal input to the decoding unit 1123. However, the reliability, which is enhanced only by error correction, is used as prior information upon feedback. Therefore, the decoding unit 1123 calculates external log likelihood ratios that are values obtained by subtracting, from the log likelihood ratios of the calculated encoded bits, the log likelihood ratios of the encoded bits input to the decoding unit 1123. An interleaving unit 1124 rearranges the order of the external log likelihood ratios of the encoded bits calculated by the decoding unit 1123 to a similar arrangement order to that of the received signal before the deinterleaving unit 1122 performs the rearrangement of the order. Then, the interleaving unit 1124 inputs external log likelihood ratios of the rearranged encoded bits to a demapping unit 1121. Then, the demapping unit 1121 performs a demapping process on the external log likelihood ratios output from the deinterleaving unit 1122.
The above processes are iterated an arbitral number of times or a predetermined number of times such that no errors are included. Finally, a hard decision unit 1125 performs hard decision on the log likelihood ratios of the information bits calculated by the decoding unit 1123, and thereby obtains the information bits included in the received signal.

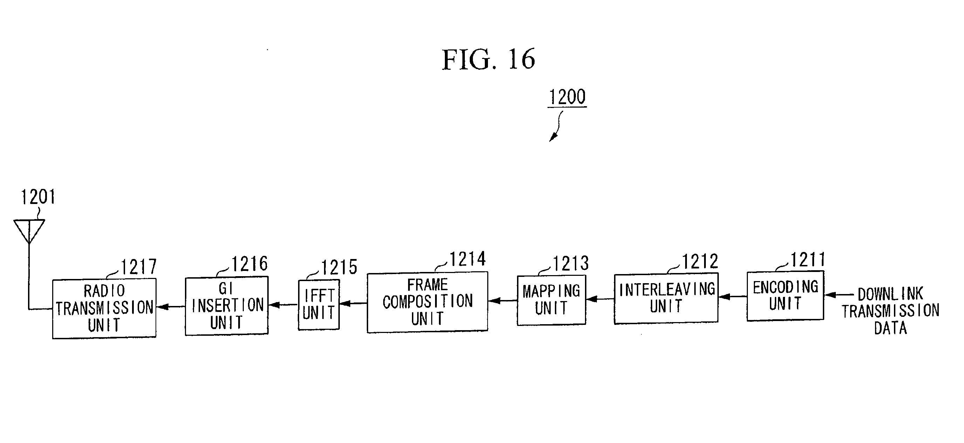

FIG. 16 is a schematic block diagram illustrating a configuration of a conventional transmission device.
A transmission device 1200 is a transmission device that performs OFDM data transmission.
Firstly, an encoding unit 1211 performs error correction coding on downlink transmission data to be transmitted to the reception device 1100. Then, the encoding unit 1211 outputs information bits indicating information concerning transmission data, and encoded bits indicating an error correction code of the information bits. An interleaving unit 1212 rearranges the order of the encoded bits included in the transmission data having been subjected to the error correction coding. A mapping unit 1213 composes a frame using the mapped modulation symbols. An IFFT (Inverse Fast Fourier Transform) unit 1215 performs IFFT on the modulation symbols composed into a frame to generate an OFDM signal.

A GI insertion unit 1216 adds a guard interval to the generated OFDM signal. A radio transmission unit 1217 converts the OFDM signal with the guard interval added into an analog signal, upconverts the analog signal into a radio frequency signal, and then transmits the radio frequency signal from an antenna 1201.

CITATION LIST

[Non-Patent Document]

[Non-Patent Document 1] A. Chindapol, and J. Ritcey, "Design, analysis and performance evaluation for BICM-ID with square QAM constellations in Rayleigh fading channels," IEEE Journal of selected areas in communications, Vol. 19, No. 5, May 2001.

DISCLOSURE OF THE INVENTION

Problems to be Solved by the Invention

Current radio communication systems use a mapping method called gray mapping. However, the gray mapping is a mapping method of arranging signal points such that adjacent signal points differ from each other only by one bit. For this reason, even if the iteration process including the demapping process and the error correction decoding process is performed based on the BICM-ID, the error rate characteristics are not improved, and a processing time increases, thereby causing larger power consumption. For this reason, there is a problem such that the BICM-ID cannot be applied to the 4th generation cellular system called LTE-A (Long Term Evolution Advanced), the standardization of which has been started under a condition that the backward compatibility with the 3.9th generation cellular system called LTE (Long Term Evolution), to which the gray mapping is applied, is maintained. Likewise, there is a problem such that the BICM-ID cannot be applied to a communication system requiring backward compatibility with a communication system to which the gray mapping is applied.
The present invention is made in consideration of the above situations. An object of the present invention is to provide a radio communication system, a radio communication method, and a communication device, to which the BICM-ID can be applied, and which can maintain backward compatibility with a communication system using the gray mapping.

Means for Solving the Problems

The present invention has been made to solve the above problems. The present invention is a radio communication system that includes: a first communication device that wirelessly transmits a downlink signal; and at least one second communication device that receives the downlink signal transmitted by the first communication device. The second communication device includes: a downlink signal reception unit that receives the downlink signal transmitted by the first communication device; and a reception device state information transmission unit that transmits reception device state information that indicates a modulation scheme and a channel encoding scheme, the second communication device being compatible with the modulation scheme. The first communication device includes: a reception device state information obtaining unit that obtains the reception device state information; a mapping control unit that selects, based on the modulation scheme indicated by the reception device state information, a mapping method of mapping between bits of the downlink signal to be transmitted to the second communication device and signal points, and outputs mapping information indicating the mapping method selected; an encoding unit that performs channel encoding on the downlink signal; a mapping unit that performs mapping on the downlink signal encoded, based on the mapping information; and a downlink signal transmission unit that transmits the downlink signal having been subjected to the mapping, based on the reception device state information.
According to the present invention, the at least one second communication device is compatible with bit interleaved coded modulation with iterative decoding. The second communication device compatible with the bit interleaved coded modulation with iterative decoding includes: a demapping unit that when post-decoding likelihood information of the downlink signal is input, performs demapping on the downlink signal based on the post-decoding likelihood information of the downlink signal and the modulation scheme with which the second communication device is compatible, the demapping unit performing demapping on the downlink signal based on the downlink signal and the modulation scheme with which the second communication device is compatible when post-decoding likelihood information of the downlink signal is not input, and the demapping unit outputting post-demapping likelihood information; and a decoding unit that performs decoding based on the post-demapping likelihood information of the downlink signal, and outputs post-decoding likelihood information of the encoded bits. The second communication device compatible with the bit interleaved coded modulation with iterative decoding iterates, for the downlink signal, demapping by the demapping unit and decoding by the decoding unit. Reception device state information of the second communication device compatible with the bit interleaved coded modulation with iterative decoding indicates that the second device is compatible with the bit interleaved coded modulation with iterative decoding.
The second communication device compatible with the bit interleaved coded modulation with iterative decoding according to the present invention includes: a deinterleaving unit that performs deinterleaving on post-demapping likelihood information of the downlink signal; and an interleaving unit that performs interleaving on post-decoding likelihood information of the downlink signal.

The mapping control unit of the first communication device according to the present invention selects any one of a gray mapping and a mapping method other than the gray mapping.

The mapping method other than the gray mapping according to the present invention comprises a set partitioning mapping.

The mapping control unit of the first communication device according to the present invention selects the mapping method other than the gray mapping when the reception device state information indicating that the reception device is compatible with bit interleaved coded modulation with iterative decoding is received.

The reception device state information of the second communication device compatible with the bit interleaved coded modulation with iterative decoding according to the present invention indicates that the second communication device is a LTE-A compatible terminal.

The mapping control unit of the first communication device according to the present invention selects the gray mapping when the reception device state information is not input.

The second communication device compatible with the bit interleaved coded modulation with iterative decoding according to the present invention includes a delay time calculation unit that calculates a delay time when demapping by the demapping unit and decoding by the decoding unit are repeatedly performed on the downlink signal having been subjected to mapping using a mapping method other than a gray mapping. When the delay time calculated exceeds an allowable maximum delay time previously determined, the reception device state information transmission unit of the second communication transmits the reception device state information that requests the downlink signal subjected to mapping using the gray mapping.

The second communication device compatible with the bit interleaved coded modulation with iterative decoding according to the present invention includes a transmission rate calculation unit that calculates a transmission rate when demapping by the demapping unit and decoding by the decoding unit are performed one time on the downlink signal having been subjected to mapping using a gray mapping. When the transmission rate calculated satisfies a request transmission rate previously determined, the reception device state information transmission unit of the second communication transmits the reception device state information that requests the downlink signal subj ected to mapping using the gray mapping.

The second communication device compatible with the bit interleaved coded modulation with iterative decoding according to the present invention is powered by a battery. The second communication device compatible with the bit interleaved coded modulation with iterative decoding includes a remaining battery power determination unit that determines whether or not a remaining amount of the battery is sufficient enough to repeatedly perform demapping by the demapping unit and decoding by the decoding unit. When it is determined that the remaining amount of the second communication device is insufficient, the reception device state information transmission unit of the second communication transmits the reception device state information that requests the downlink signal subjected to mapping using the gray mapping.

The second communication device compatible with the bit interleaved coded modulation with iterative decoding according to the present invention includes: an iteration number calculation unit that calculates the maximum iteration number of times for which demapping by the demapping unit and decoding by the decoding unit are repeatedly performed on the downlink signal, the maximum iteration number of times satisfying an allowable maximum delay time previously determined; and a process characteristic comparison unit that calculates and compares an error rate when demapping by the demapping unit and decoding by the decoding unit are performed the maximum iteration number of times on the downlink signal subjected to mapping using a mapping method in which adjacent signal points differ from each other by two bits or more, the downlink signal being transmitted by the first communication device, and an error rate when demapping by the demapping unit and decoding by the decoding unit are performed one time on the downlink signal subjected to mapping using gray mapping, the downlink signal being transmitted by the first communication device. The reception device state information transmission unit of the second communication transmits the reception device state information that requests the downlink signal subjected to mapping using the mapping method with the lower error rate.

The present invention is a radio communication method for a first communication device and a second communication device to communicate with each other. The first communication device is provided with a plurality of mapping methods of assigning a plurality of encoded bits to a modulation symbol of transmission data modulated based on multi-level modulation. The first communication device transmits the plurality of encoded bits assigned based on one of the plurality of mapping methods that is selected based on a request from the second communication device.

The request from the second communication device according to the present invention indicates which demapping method compatible with the plurality of mapping methods the second communication device is provided with.

The request from the second communication device according to the present invention indicates a quality of service of a channel from the first communication device to the second communication device.

The request from the second communication device according to the present invention indicates an allowable maximum delay time.

The present invention is a communication device that receives encoded bits assigned by one of a plurality of mapping methods of assigning a plurality of encoded bits to a modulation symbol of transmission data modulated based on multi-level modulation. The communication device comprises a connection request process unit that determines a mapping method based on information indicating which demapping method compatible with the plurality of mapping methods is provided.

The connection request process unit according to the present invention determines a mapping method based on information concerning a quality of service of a received signal.

The connection request process unit according to the present invention determines a mapping method based on an allowable maximum delay time.

Effects of the Invention

According to the present invention, the transmission device determines a mapping method for a downlink signal based on the reception device state information received from the reception device. Accordingly, the transmission device can transmit the downlink signal by the mapping method with which the reception device is compatible. Thus, the downlink signal having been subjected to a mapping suited to the BICM-ID can be transmitted to the reception device to which the BICM-ID is applied, and which is backward compatible with a reception device using the gray mapping.

BRIEF DESCRIPTION OF THE DRAWINGS

FIG. 1 is a schematic block diagram illustrating a configuration of a reception device according to a first embodiment of the present invention.

FIG. 2 is a schematic block diagram illustrating a configuration of a demapping/decoding unit included in the reception device.

FIG. 3 is a schematic block diagram illustrating a configuration of a transmission device according to the first embodiment of the present invention.

FIG. 4 is a schematic block diagram illustrating a configuration of an encoding/mapping unit.

FIG. 5 is a flowchart illustrating a process of the demapping/decoding unit.

FIG. 6 illustrates signal points based on set partitioning mapping for 16QAM.

FIG. 7 illustrates signal points based on gray mapping for 16QAM.

FIG. 8 illustrates signal points based on modified set partitioning mapping for 16QAM.

FIG. 9 illustrates signal points based on random mapping for 16QAM.

FIG. 10 illustrates signal points based on mixed mapping for 16QAM.

FIG. 11 is a schematic block diagram illustrating a configuration of a demapping/decoding unit including no subtraction unit.

FIG. 12 is a schematic block diagram illustrating a configuration of a reception device according to a second embodiment of the present invention.

FIG. 13 is a schematic block diagram illustrating a configuration of a reception device according to a third embodiment of the present invention.

FIG. 14 is a graph illustrating an error rate of signal detection based on BICM-ID and an error rate of signal detection based on gray mapping.

FIG. 15 is a schematic block diagram illustrating a configuration of a conventional reception device to which BICM-ID is applied.

FIG. 16 is a schematic block diagram illustrating a configuration of a conventional transmission device to which BICM-ID is applied.

FIG. 17 illustrates signal points based on modified set partitioning mapping for 16QAM.

BEST MODE FOR CARRYING OUT THE INVENTION

(First Embodiment)

Hereinafter, a first embodiment of the present invention is explained in detail with reference to accompanying drawings.

A communication system according to the first embodiment of the present invention includes a reception device (second communication device) 200a and a transmission device (first communication device) 300. The reception device 200a and the transmission device 300 perform 16QAM modulation. The reception device 200a is compatible with the BICM-ID. A transmission device 100 is included in, for example, a base station device in a cellular system. The reception device 200a is included in, for example, a mobile station device.

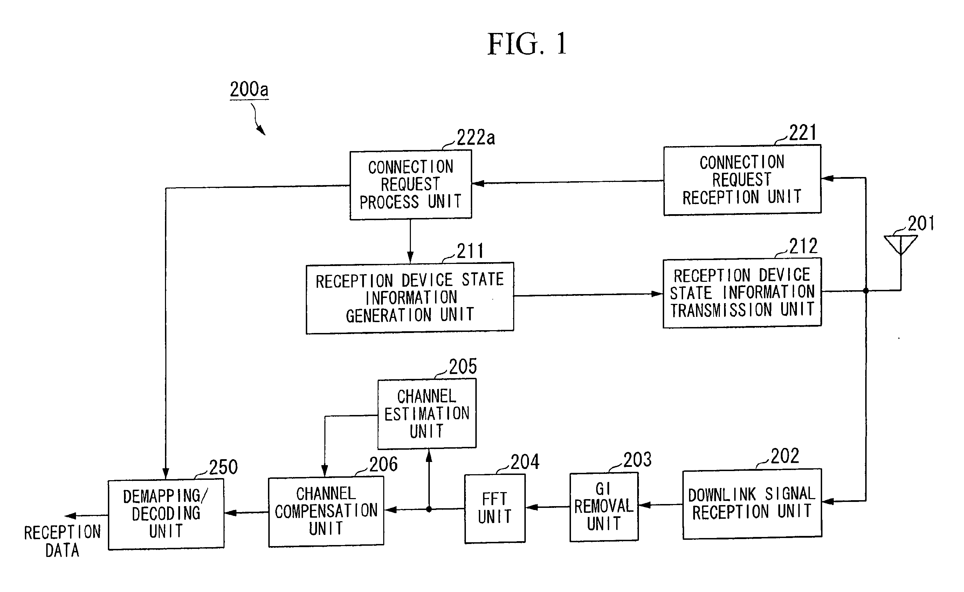

FIG. 1 is a schematic block diagram illustrating a configuration of the reception device 200a according to the first embodiment of the present invention.

The reception device 200a includes: a downlink signal reception unit 202; a GI removal unit 203; an FFT unit 204; a channel estimation unit 205; a channel compensation unit 206; a reception device state information generation unit 211; a reception device state information transmission unit 212; a connection request reception unit 221; a connection request process unit 222a; and a demapping/decoding unit 250.

An antenna 201 performs transmission and reception of a signal. The downlink signal reception unit 202 receives a downlink signal through the antenna 201, downconverts the received downlink signal into a baseband signal, and then converts the baseband signal into a digital signal. The GI removal unit 203 removes a guard interval from the downlink signal converted into the digital signal. The FFT unit performs Fourier transform to covert the downlink signal, from which the guard interval has been removed, into a frequency domain signal, and then demultiplexes modulation symbols of each subcarrier. The channel estimation unit 205 estimates a complex gain of a channel of each subcarrier. The channel compensation unit 206 compensates modulation symbols on each subcarrier using the estimated complex gain. The demapping/decoding unit 250 performs demapping and decoding, and detects downlink reception data.

The reception device state information generation unit 211 generates reception device state information. The reception device state information transmission unit 212 transmits the reception device state information through the antenna 201. The connection request reception unit 221 receives a connection request through the antenna 201. The connection request process unit 222a outputs a reception device state information generation command to the reception device state information generation unit 211 according to transmission device information included in the connection request. Additionally, the connection request process unit 222a outputs mapping information to the demapping/decoding unit 250.

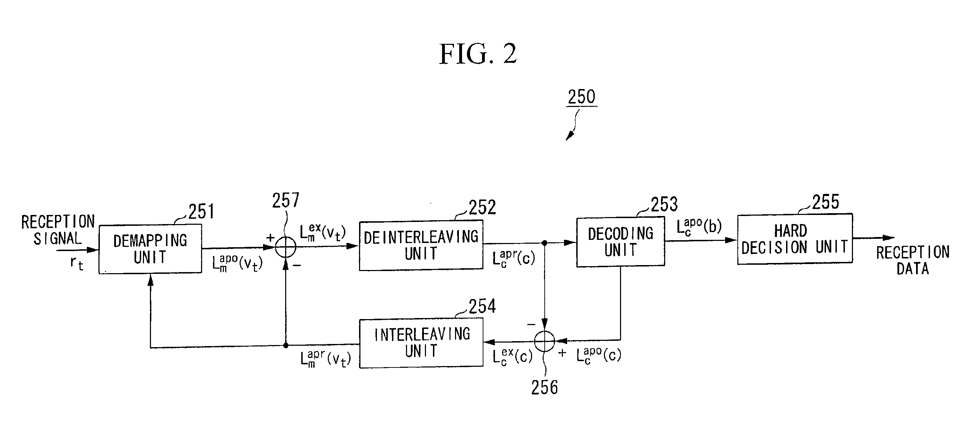

FIG. 2 is a schematic block diagram illustrating a configuration of the demapping/decoding unit 250 included in the reception device.

The demapping/decoding unit 250 includes: a demapping unit 251; a deinterleaving unit 252; a decoding unit 253; an interleaving unit 254; a hard decision unit 255; a subtraction unit 256; and a subtraction unit 257. The demapping unit 251 decomposes a received signal into likelihoods of respective encoded bits, where the likelihoods are log likelihood ratios. The deinterleaving unit 252 rearranges the order of the log likelihood ratios of the respective encoded bits. The decoding unit 253 performs error correction decoding on the log likelihood ratios, the arrangement order of which has been changed. Then, the decoding unit 253 calculates log likelihood ratios of information bits included in the received signal, and log likelihood ratios of encoded bits included in the received signal. The interleaving unit 254 rearranges the order of the log likelihood ratios of the encoded bits included in the received signal to a similar arrangement order to that of the received signal before the interleaving unit 254 performs the rearrangement of the order. The hard decision unit 255 performs hard decision on the log likelihood ratios of the information bits included in received information, and thus obtains information bits included in the received signal. The subtraction unit 256 subtracts the log likelihood ratios of the encoded bits output from the deinterleaving unit 252 from the log likelihood ratios of the encoded bits output from the decoding unit 253. The subtraction unit 257 subtracts the log likelihood ratios of the encoded bits output from the interleaving unit 254 from the log likelihood ratios of the encoded bits output from the demapping unit 251.

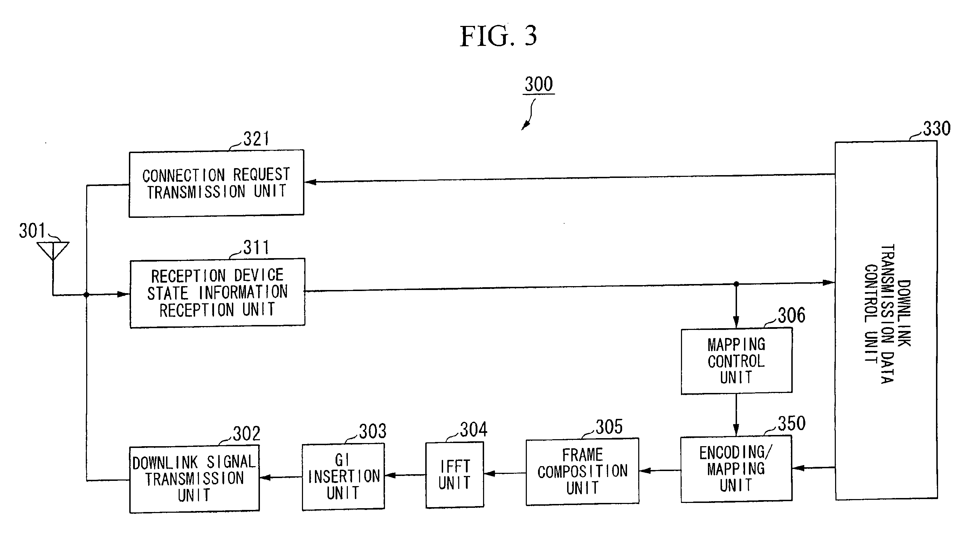

FIG. 3 is a schematic block diagram illustrating a configuration of the transmission device 300 according to the first embodiment of the present invention.

The transmission device 300 includes: an antenna 301; a downlink signal transmission unit 302; a GI insertion unit 303; an IFFT unit 304; a frame composition unit 305; a mapping control unit 306; a reception device state information reception unit (reception device state information obtaining unit) 311; a connection request transmission unit 321; a downlink transmission control unit 330; and an encoding/mapping unit 350.

The antenna 301 performs transmission and reception of a signal. The connection request transmission unit 321 transmits a connection request to the reception device 200a through the antenna 301. The reception device state information reception unit 311 receives, through the antenna 301, reception device state information from the reception device 200a. Based on the reception device state information, the mapping control unit 306 outputs mapping control information that determines a mapping method. Based on the mapping control information, the encoding/mapping unit 350 performs mapping and encoding of downlink transmission data to generate modulation symbols. The frame composition unit 305 composes a frame using the mapped modulation symbols. The IFFT unit 304 performs inverse Fourier transform on the modulation symbols composed into a frame to generate a downlink signal. The GI insertion unit 303 inserts a guard interval into the downlink signal. The downlink signal transmission unit 302 converts the OFDM signal, into which the guard interval has been inserted, into an analog signal. Then, the downlink signal transmission unit 302 transmits the analog signal to the reception device 200a through the antenna 301.

The downlink transmission data control unit 330 outputs a connection request transmission command to the connection request transmission unit 321. Additionally, upon receiving reception device state information, the downlink transmission data control unit 330 outputs downlink transmission data to the encoding/mapping unit 350.

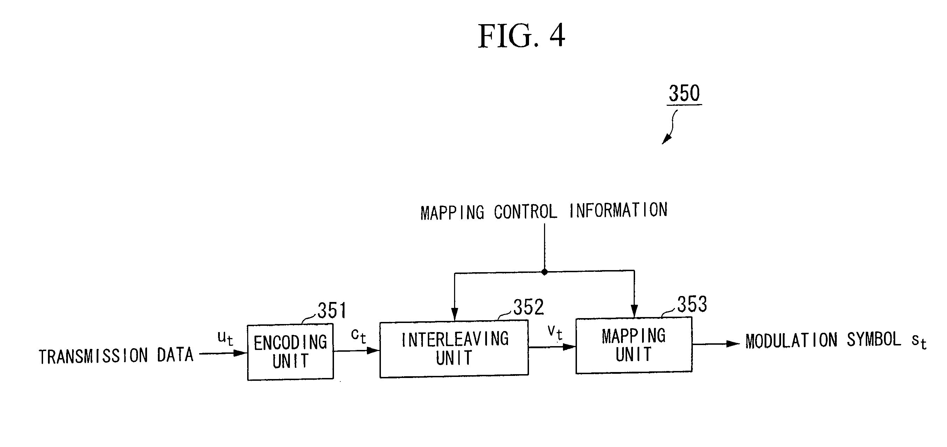

FIG. 4 is a schematic block diagram illustrating a configuration of the encoding/mapping unit 350.

The encoding/mapping unit 350 includes: an encoding unit 351; an interleaving unit 352; and a mapping unit 353. The encoding unit 351 performs error correction coding on transmission data, and outputs information bits indicating information concerning transmission data and encoded bits indicating an error correction code of information bits. The interleaving unit 352 rearranges the order of the encoded bits based on the mapping control information. The mapping unit 353 maps the encoded bits onto modulation symbols based on the mapping control information.

Hereinafter, an operation of the radio communication system according to the first embodiment is explained. Firstly, the downlink transmission data control unit of the transmission device 300 outputs a connection request transmission command to the connection request transmission unit 321 upon receiving a transmission command with respect to the reception device 200a or the like. Upon receiving the connection request transmission command, the connection request transmission unit 321 transmits a connection request to the reception device 200a through the antenna 321. At this time, the connection request includes information concerning the transmission device 300, which includes a compatible mapping method, and the like.

Then, the connection request reception unit 221 of the reception device 200a receives the connection request through the antenna 201. When the connection request reception unit 221 receives the connection request, the connection request process unit 222a obtains information concerning the transmission device from the received connection request. The connection request process unit 222a determines a mapping method and a modulation method based on the obtained information concerning the transmission device. Then, the connection request process unit 222a outputs the mapping information and the reception device state information generation command to the demapping/decoding unit 250 and the reception device state information generation unit 211, respectively.

Upon receiving the reception device state information generation command, the reception device state information generation unit 211 generates reception device state information indicating that the reception device is compatible with the BICM-ID. When the transmission device 300 is compatible with only gray mapping, however, the reception device state information generation unit 211 generates reception device state information that requests transmission of signals based on gray mapping. When the reception device state information generation unit 211 generates reception device state information, the reception device state information transmission unit 212 transmits the generated reception device state information to the transmission device 300 through the antenna 201.

The reception device state information reception unit 311 of the transmission unit 300 receives, through the antenna 201, the reception device state information from the reception device 200a. When the reception device state information reception unit 311 receives the reception device state information, the mapping control unit 306 selects a mapping method based on the reception device state information. When the reception device state information indicates that the reception device is compatible with the BICM-ID, the mapping control unit 306 selects a set partitioning mapping as a mapping method. The set partitioning mapping is a mapping method performed based on a set partitioning method. The set partitioning method is a dividing method in which 16QAM signal points are continuously divided into several subsets so that the minimum distance among signal points included in each subset increases monotonically. The reason that the set partitioning mapping is selected when the reception device state information indicates that the reception device is compatible with the BICM-ID will be explained in detail later.

When the reception device state information indicates that the reception device is incompatible with the BICM-ID, when the reception device state information requests transmission of signals based on the gray mapping, or when a connection response including no reception device state information is received, the mapping control unit 306 selects the gray mapping as a mapping method. The gray mapping is a mapping method in which adjacent signal points differ from each other by only one bit. The mapping control unit 306 generates mapping control information based on the selected mapping method.

When the reception device state information reception unit 311 receives the reception device state information, the downlink transmission data control unit 330 outputs downlink transmission data to the encoding/mapping unit 350.

When the downlink transmission control unit 330 outputs the downlink transmission data, the encoding unit 351 of the encoding/mapping unit 350 encodes the obtained downlink transmission data, and outputs information bits indicating information concerning transmission data, and encoded bits indicating an error correction code of the information bits. The interleaving unit 352 rearranges the order of the encoded bits of the downlink transmission data based on the mapping control information generated by the mapping control unit 306. Based on the mapping control information generated by the mapping control unit 306, the mapping unit 353 performs mapping on the downlink transmission data having been subjected to the rearrangement of the order of the encoded bits, and outputs modulation symbols.

The frame composition unit 305 inserts a pilot signal, a channel multiplexing control signal TPS (Transmission Parameter Signaling), and a null signal, in addition to the mapped modulation symbols to compose an OFDM frame. Then, the IFFT unit 304 performs, for each bandwidth, inverse Fourier transform to convert the modulation symbols composed into a frame into a time domain signal to generate a downlink signal. Then, the GI insertion unit 303 inserts a guard interval into the downlink signal. Then, the downlink signal transmission unit upconverts the downlink signal into a radio frequency signal, and then transmits the radio frequency signal to the reception device 200a through the antenna 301.

The downlink signal reception unit 202 of the reception device 200a receives the downlink signal through the antenna 201. When the downlink signal reception unit 202 receives the downlink signal, the GI removal unit 203 removes the guard interval from the received downlink signal. Then, the FFT unit 204 performs Fourier transform on the downlink signal from which the guard interval has been removed, and then decomposes modulation symbols of each subcarrier. Then, the channel estimation unit 205 estimates a complex gain of a channel of each subcarrier. When the channel estimation unit 205 estimates the complex gain of the channel, the channel compensation unit 206 compensates the modulation symbols on each subcarrier using the estimated complex gain.

Hereinafter, a process of the demapping/decoding unit 250 is explained.

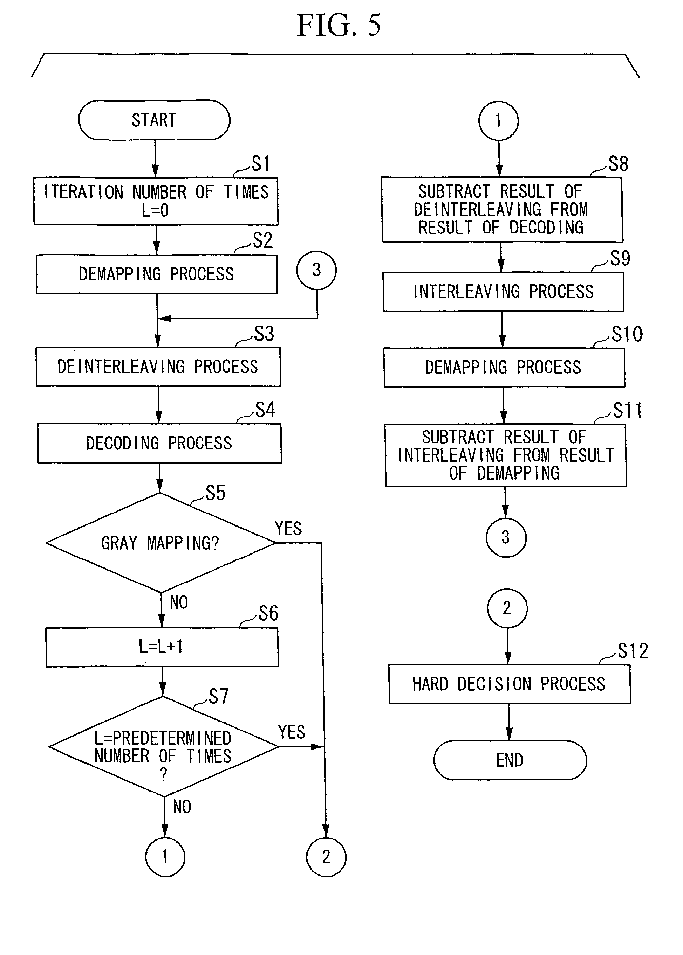

FIG. 5 is a flowchart illustrating a process of the demapping/decoding unit.

Firstly, when the channel compensation unit 206 compensates the modulation symbols, the compensated modulation symbols are output to the demapping/decoding unit 250. At this time, the modulation symbols $r_t$ can be expressed as expression (1).

[Expression 1]

$$r_t = \rho_t s_t + n_t \qquad \cdots (1)$$

$\rho_t$ denotes a fading coefficient concerning an OFDM subcarrier. $s_t$ denotes a modulation symbol. $n_t$ denotes noises on each modulation symbol.

Upon receiving the compensated modulation symbol $r_t$, the demapping/decoding unit 250 registers the iteration number of times L=0 on a memory (not shown) included in the demapping/decoding unit 250 (step S1). When the modulation symbol $r_t$ is input to the demapping/decoding unit 250, the demapping unit 251 performs demapping on the modulation symbols based on the mapping information generated by the connection request process unit 222a, and calculates the log likelihood ratios $L_m^{apo}$ of the encoded bits (step S2). At this time, $L_m^{apo}$ can be expressed as expression (2).

[Expression 2]

$$L_m^{apo}(v_t^i) = \log \frac{\displaystyle\sum_{s_t \in \chi_{t,1}^i} P(r_t \mid s_t)}{\displaystyle\sum_{s_t \in \chi_{t,0}^i} P(r_t \mid s_t)} \qquad \cdots (2)$$

$V_t^i$ denotes an i-th encoded bit of a t-th modulation signal. $\chi_{t,1}^i$ and $\chi_{t,0}^i$ denote sets of modulation symbols where the i-th bit is 1 and 0 of the t-th modulation signal, respectively. $\chi_{t,1}^i$ and $\chi_{t,0}^i$ are sets of modulation symbols, which have $2^{4-1}=8$ patterns, since one of four bits is fixed. $P(r_t|s_t)$ denotes a conditional probability distribution of $s_t$ with respect to $r_t$. Each $P(r_t|s_t)$ can be obtained since $n_t$ of expression (1) obeys the complex Gaussian distribution. When variance of noises added to one symbol is $2\sigma^2$, $P(r_t|s_t)$ can be expressed as expression (3).

[Expression 3]

$$P(r_t \mid s_t) = \frac{1}{2\pi\sigma^2} \exp\left(-\frac{\|r_t - \rho_t s_t\|^2}{2\sigma^2}\right) \qquad \cdots (3)$$

‖·‖ denotes a Euclidean norm.
Accordingly, from expressions (2) and (3), $L_m{}^{apo}$ can be expressed as expressions (4).
[Expression 4]

$$L_m{}^{apo}(v_t{}^i) = \log \frac{\sum\limits_{s_t \in \chi^i{}_{t,1}} \exp(-\frac{\|r_t - \rho_t s_t\|^2}{2\sigma^2})}{\sum\limits_{s_t \in \chi^i{}_{t,0}} \exp(-\frac{\|r_t - \rho_t s_t\|^2}{2\sigma^2})} \quad \cdots (4)$$

Further, if Max-Log approximation is applied to expression (4), $L_m{}^{apo}(V_t{}^i)$ can be expressed as expressions (5).
[Expression 5]

$$L_m{}^{apo}(v_t{}^i) = \frac{1}{2\sigma^2}\left( \min_{s_t \in \chi^i{}_{t,0}} \|r_t - \rho_t s_t\|^2 - \min_{s_t \in \chi^i{}_{t,1}} \|r_t - \rho_t s_t\|^2 \right)$$

$$\cdots (5)$$

The demapping unit 251 calculates the log likelihood ratios of the encoded bits $L_m{}^{apo}(v_t{}^i)$ using expression (5) obtained in this manner.
Then, the log likelihood ratios of the encoded bits $L_m{}^{apo}(v_t{}^i)$ generated by the demapping unit 251 is input to the subtraction unit 257. However, there is no output from the interleaving unit 254, and therefore the log likelihood ratios of the encoded bits $L_m{}^{apo}(v_t{}^i)$ are input to the deinterleaving unit 252 as they are. Based on the mapping information generated by the connection request process unit 222a, the deinterleaving unit 252 rearranges the order of the log likelihood ratios of the encoded bits $L_m{}^{apo}(v_t{}^i)$ to the arrangement order before the interleaving (step S3). The prior log likelihood ratios $L_c{}^{apr}(c)$ having been subjected to the rearrangement of order are input to the decoding unit 253, where c denotes an encoded bit sequence. The encoded bit sequence denotes a sequence of the encoded bits included in the received data input to the demapping unit 251. The decoding unit 253 performs error correction decoding on the prior log likelihood ratios $L_c{}^{apr}(c)$ having been subjected to the rearrangement of order to calculate posterior log likelihood ratios of the information bits $L_c{}^{apo}(c)$ and posterior log likelihood ratios of the encoded bits $L_c{}^{apo}(b)$ (step S4), where b denotes an information bit sequence. The information bit sequence denotes a sequence of the information bits included in the received data input to the demapping unit 251.
After the decoding process, the demapping/decoding unit 250 obtains the mapping information generated by the connection request process unit 222a, and determines whether a mapping method applied to the received signal is gray mapping (step S5). If the mapping method applied to the received signal is not gray mapping, the demapping/decoding unit 250 adds 1 to the iteration number of times L, which is registered on the memory (step S6). After adding 1 to the iteration number of times L, the demapping/decoding unit 250 determines whether or not the iteration number of times L is equal to a predetermined number of times (step S7). If the iteration number of times L is less than the predetermined number of times, the subtraction unit 256 subtracts the log likelihood ratios of the encoded bits $L_c{}^{apr}(c)$ output from the deinterleaving unit 252 from the posterior log likelihood ratios of the encoded bits $L_c{}^{apo}(c)$ output from the decoding unit 253 to generate external log likelihood ratios $L_c{}^{ex}(c)$ (step S8). Based on the mapping information generated by the connection request process unit 222a, the interleaving unit 254 rearranges the order of the external log likelihood ratios $L_c{}^{ex}(c)$ generated by the subtraction unit 256.
Then, the demapping unit 251 performs demapping on the external log likelihood ratios $L_m{}^{apr}(v_t)$ having been subjected to the rearrangement of order, and outputs the posterior log likelihood ratios $L_m{}^{apo}(v_t)$ (step S10). This dem-

apping is the second iteration process or more. At this time, with use of expression (3), the posterior log likelihood ratios $L_m^{apo}(v_t)$ can be expressed as expression (6).

[Expression 6]

$$L_m^{apo}(v_t^i) = L_m^{apr}(v_t^i) + \log \frac{\left( \sum\limits_{s_t \in \chi^i_{t,1}} \exp\left(-\frac{\|r_t - \rho_t s_t\|^2}{2\sigma^2}\right) \sum\limits_{\substack{\tilde{v}_t^j(s_t)=1 \\ j \neq 1}}^{q} \tilde{v}_t^j(s_t) L_m^{apr}(v_t^j) \right)}{\left( \sum\limits_{s_t \in \chi^i_{t,0}} \exp\left(-\frac{\|r_t - \rho_t s_t\|^2}{2\sigma^2}\right) \sum\limits_{\substack{\tilde{v}_t^j(s_t)=1 \\ j \neq 1}}^{q} \tilde{v}_t^j(s_t) L_m^{apr}(v_t^j) \right)}$$

$$\cdots (6)$$

$\tilde{v}_t^j(s_t)$ denotes aj-th bit of a combination of four bits corresponding to the t-th modulation symbol $s_t$. Accordingly, $\tilde{v}_t^j(s_t)$ is 1 or 0. Hereinafter, although "~" is appended right after an alphabetical character, "~" is assumed to be appended right above the alphabetical character. q denotes the number of bits included in the modulation symbol. Accordingly, q=4 in the present embodiment.

Further, when the Max-Log approximation is used with respect to expression (6), the posterior log likelihood ratios $L_m^{apo}(v_t)$ can be expressed as expression (7).

[Expression 7]

$$L_m^{apo}(v_t^i) = L_m^{apr}(v_t^i) + \frac{1}{2\sigma^2}\left( \min_{s_t \in \chi^i_{t,0}} \|r_t - \rho_t s_t\|^2 \sum\limits_{\substack{\tilde{v}_t^j(s_t)=1 \\ j \neq 1}}^{q} \tilde{v}_t^j(s_t) L_m^{apr}(v_t^j) \right)$$

$$- \frac{1}{2\sigma^2}\left( \min_{s_t \in \chi^i_{t,1}} \|r_t - \rho_t s_t\|^2 \sum\limits_{\substack{\tilde{v}_t^j(s_t)=1 \\ j \neq 1}}^{q} \tilde{v}_t^j(s_t) L_m^{apr}(v_t^j) \right)$$

$$\cdots (7)$$

With use of expression (7) obtained in this manner, the demapping unit 251 calculates the log likelihood ratios of the encoded bits $L_m^{apo}(v_t^i)$ for the second time or more.

Then, the subtraction unit 257 subtracts the external log likelihood ratios $L_m^{apr}(v_t)$, the order of which has been rearranged by the interleaving unit 254, from the posterior log likelihood ratios $L_m^{apo}(v_t)$ output from the demapping unit 251, and inputs the result of the subtraction to the deinterleaving unit 252 (step S11). Hereinafter, the processes from step S3 are iterated.

If it is determined in step S5 that the mapping method is the gray mapping, or if it is determined in step S7 that the iteration number of times L is equal to the predetermined number of times, the hard decision unit 255 performs hard decision on the log likelihood ratios of the information bits output from the decoding unit 253, and obtains the received data. The deinterleaving unit 254 rearranges the order of the log likelihood ratios of the encoded bits included in the received information to a similar arrangement order to that of the received signal before the interleaving unit 254 performs the rearrangement of order. The hard decision unit 255 performs a hard decision on the log likelihood ratios of the information bits included in the received information, and thus obtains the information bits included in the received signal.

Here, the reason that the mapping control unit 306 selects the set partitioning mapping when the reception device state information received by the transmission device 300 indicates that the reception device is compatible with the BICM-ID is explained.

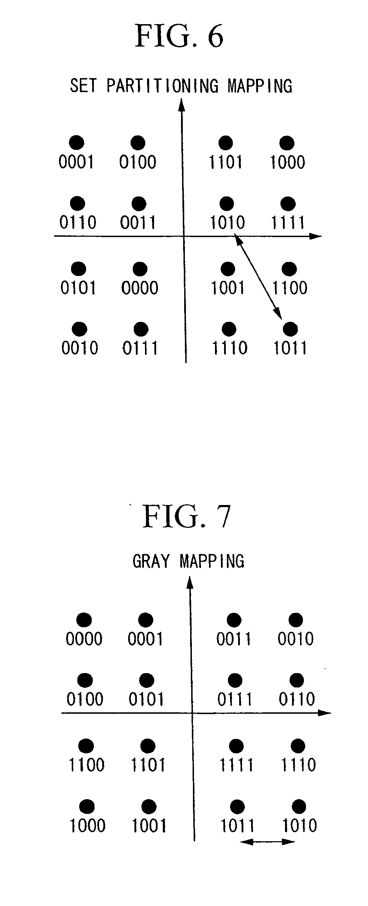

FIG. 6 illustrates signal points based on set partitioning mapping for 16QAM.

FIG. 7 illustrates signal points based on gray mapping for 16QAM.

Horizontal axes shown in FIGS. 6 and 7 denote the amplitude of an in-phase component of the received signal. Vertical axes shown in FIGS. 6 and 7 denote the amplitude of an orthogonal component of the received signal. The set partitioning mapping shown in FIG. 6 is a mapping method performed based on a set partitioning method. The set partitioning method is a dividing method in which, for example, 16QAM signal points are continuously divided into several subsets so that the minimum distance among signal points included in each subset increases monotonically. The gray mapping shown in FIG. 7 is a mapping method in which adjacent signal points differ from each other by only one bit.

According to the BICM-ID, when there is no prior information (likelihood ratios of encoded bits that are obtained by an error correction decoding), all the signal points have the same probability of being transmitted. For this reason, the signal point, which is closest to a received signal point, is regarded as a signal point having the highest probability of having been transmitted. On the other hand, if the first to third bits of four bits denoting a signal point shown in FIG. 6 are recognized, the number of signal points can be limited to two. For example, if the first to third bits are recognized as 011, the number of signal points can be limited to two of 0011 and 1011.

For this reason, the distance from the received signal point to 1011 and the distance from the received signal point to 1010 are calculated, and then the signal point that is closer to the received signal point is determined as having been transmitted.

Thus, received bits are recognized, and thereby signal points having different bits from the recognized bits can be excluded, thereby enabling an increase in distances among signal points. If the result of the iteration process converges in the case of the BICM-ID, even if multiple bits are transmitted by one symbol based on multi-level decoding, the performance is determined based on the distance between two signal points differing from each other by only one bit, and therefore the error rate characteristics can be improved.

On the other hand, even if the first to third bits of the four bits denoting a signal point shown in FIG. 7 are recognized, the distances among signal points cannot be increased. For example, when the first to third bits are recognized as 011, the number of signal points can be limited to two of 0011 and 1011. However, 1011 and 1010 are positioned adjacent to each other, the distance therebetween does not differ from before the first to third bits are recognized. For this reason, the error rate characteristics are not improved.

Accordingly, since the result of the iteration process can converge by means of the BICM-ID, the mapping control unit 306 selects the set partitioning mapping when the received reception device state information indicates that the reception device is compatible with the BICM-ID.

As explained above, according to the first embodiment, the transmission device 300 determines a mapping method for a downlink signal based on the reception device state information received from the reception device 200a. Accordingly, the transmission device 300 can transmit the downlink signal by the mapping method with which the reception device 200a is compatible. Thus, a downlink signal having been subjected to a mapping suited to the BICM-ID can be transmitted to the reception device 200a, to which the BICM-ID is applied, and which is backward compatible with the reception device 200a using the gray mapping.

Although the first embodiment of the present invention has been explained in detail with reference to the accompanying drawings, the detailed configuration is not limited to the above. Various design modifications can be made without departing from the scope of the present invention.

For example, the case where the radio communication system performs OFDM communication has been explained in the present embodiment. However, the present embodiment is not limited thereto. Instead, the radio communication system may perform multi-carrier communication or single-carrier communication other than OFDM communication.

Additionally, the case where the radio communication system performs mapping and demapping with use of 16QAM modulation as a multi-level modulation scheme has been explained in the present embodiment. However, the present embodiment is not limited thereto. Instead, another multi-level modulation scheme, such as QPSK, 8PSK, or 64QAM, may be used.

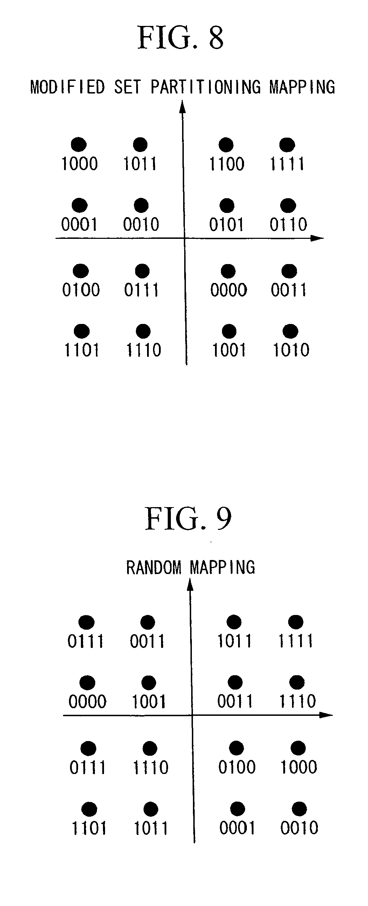

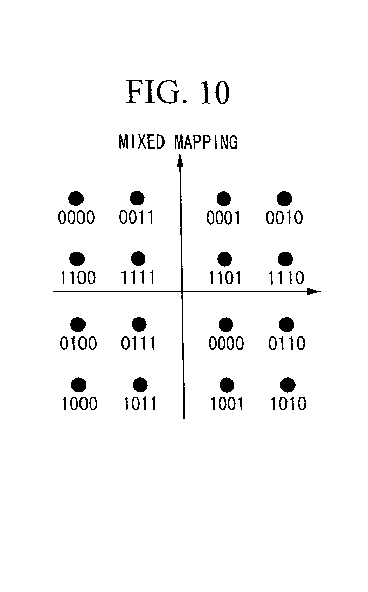

The case where the radio communication system uses the set partitioning mapping as a mapping method compatible with the BICM-ID has been explained in the present embodiment. However, the present embodiment is not limited thereto. Instead, a mapping method in which signal points differing from each other by only one bit are arranged at a distance that is farther than in the case of the gray mapping, such as the modified set partitioning mapping shown in FIG. 8, random mapping shown in FIG. 9, or mixed mapping shown in FIG. 10, may be used.

FIG. 8 illustrates signal points based on modified set partitioning mapping for 16QAM.

FIG. 9 illustrates signal points based on random mapping for 16QAM.

FIG. 10 illustrates signal points based on mixed mapping for 16QAM.

Horizontal axes shown in FIGS. 8 to 10 denote the amplitude of an in-phase component of the received signal. Vertical axes shown in FIGS. 8 to 10 denote the amplitude of an orthogonal component of the received signal. The modified set partitioning mapping shown in FIG. 8 is a mapping method in which adjacent signal points differ from each other by two bits or more. The random mapping shown in FIG. 9 is a mapping method in which signal points are arranged randomly. The mixed mapping is a mapping method in which the modified set partitioning mapping and the gray mapping are mixed.

Further, the case where the demapping/decoding unit 250 includes the subtraction units 256 and 257 has been explained in the present embodiment. However, the present embodiment is not limited thereto. Instead, the demapping unit 251 and the decoding unit 253 may directly calculate the external log likelihood ratios so that the demapping/decoding unit 250 is configured not to include the subtraction units 256 and 257.

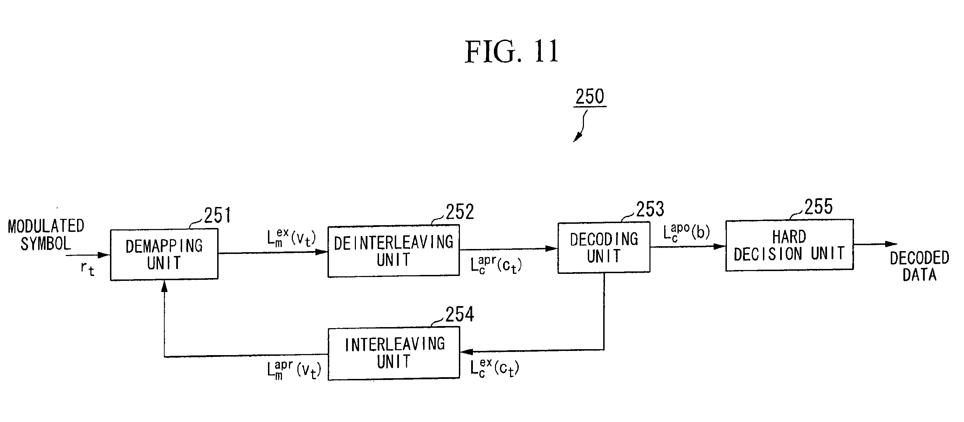

FIG. 11 is a schematic block diagram illustrating a configuration of a demapping/decoding unit including no subtraction unit.

The demapping/decoding unit 250, which includes no subtraction unit, has the configuration of the demapping/decoding unit 250 from which the subtraction units 256 and 257 are excluded. Operations of the demapping unit 251 and the decoding unit 253 differ from those of the first embodiment.

The demapping unit 251 directly calculates the external log likelihood ratios of the encoded bits $L_m^{ex}$. The calculation of the external log likelihood ratios $L_m^{ex}$ is performed based on expression (8).

[Expression 8]

$$
L_m^{ex}(v_t^i) = \frac{1}{2\sigma^2}\left( \min_{s_t \in \chi^i_{t,0}} \|r_t - \rho_t s_t\|^2 \quad \sum_{\substack{\tilde{v}_t^j(s_t)=1 \\ j \neq 1}}^{q} \tilde{v}_t^j(s_t) L_m^{apr}(v_t^j) \right)
$$
$$
- \frac{1}{2\sigma^2}\left( \min_{s_t \in \chi^i_{t,1}} \|r_t - \rho_t s_t\|^2 \quad \sum_{\substack{\tilde{v}_t^j(s_t)=1 \\ j \neq 1}}^{q} \tilde{v}_t^j(s_t) L_m^{apr}(v_t^j) \right)
$$

$\cdot\cdot\cdot(8)$

The decoding unit 253 calculates the external log likelihood ratios of the encoded bits $L_c^{ex}$ (c) and the posterior log likelihood ratios of the information bits $L_c^{apo}$ (b). The decoding unit 253 inputs the calculated posterior log likelihood ratios of the information bits $L_c^{apo}$ (b) to the interleaving unit 254.

Thus, decoding by the iteration process can be performed without the subtraction units 256 and 257 being included in the demapping/decoding unit 250.

The case where the reception device 200a generates the reception device state information indicating that the reception device 200a is compatible with the BICM-ID has been explained in the present embodiment. However, the present embodiment is not limited thereto. For example, the reception device 200a may transmit the reception device state information indicating that the reception device 200a is an LTE-A reception device when the LTE-A reception device is compatible with the BICM-ID. Then, the transmission device 300 receives the reception device state information, and then generates a downlink signal by a mapping method compatible with the BICM-ID when the reception device state information indicates that the reception device 200a is an LTE-A reception device. Thus, the LTE-A reception device can apply the BICM-ID and maintain backward compatibility with LTE.

(Second Embodiment)

Hereinafter, a second embodiment of the present invention is explained. The second embodiment is an example of a radio communication system that adaptively determines a mapping method based on a QoS (Quality of Service).

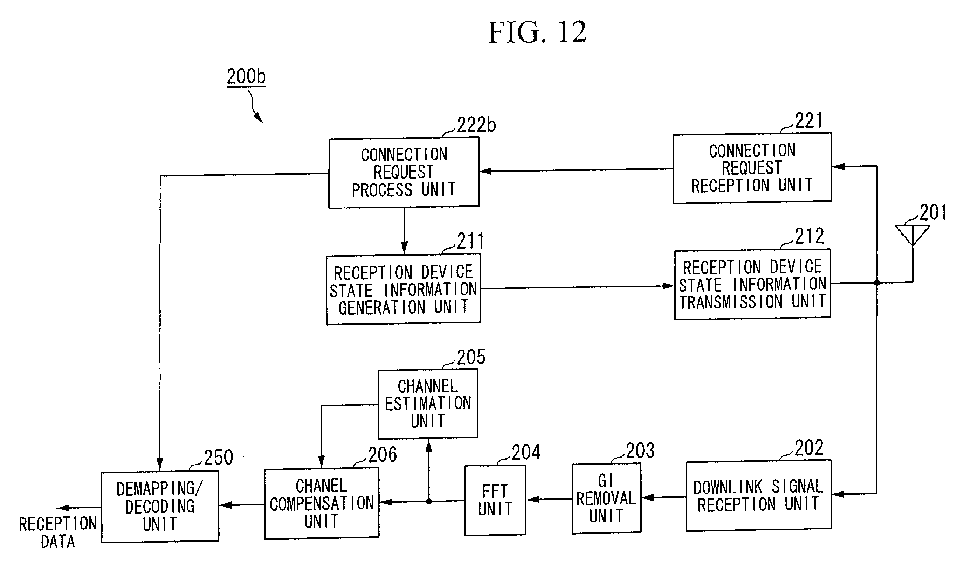

FIG. 12 is a schematic block diagram illustrating a configuration of a reception device according to a second embodiment of the present invention.

A reception device 200b of the second embodiment differs from the reception device 200a of the first embodiment in that the connection request process unit 222a of the reception device 200a is replaced with a connection request process unit 222b. Since other process units are the same as those included in the reception device 200a of the first embodiment, explanations are given using the same reference numerals. Additionally, since the configuration of the transmission device 300 is the same as that of the transmission device 300 of the first embodiment, explanations are given using the same reference numerals.

In the present embodiment, the connection request process unit 222b of the reception device 200b (a transmission rate calculation unit, a delay time calculation unit) selects a signal detection method satisfying a QoS expressed by a request transmission rate or an allowable maximum delay time.

Firstly, the connection request process unit 222b calculates a signal-to-noise ratio of a connection request signal received from the transmission device 300. Then, based on the calculated signal-to-noise ratio, the connection request process unit 222b determines whether or not signal detection can be performed without the iteration process based on the BICM-ID when signals are transmitted at the request transmission rate based on the gray mapping. The connection request process unit 222b previously registers, on an internal memory, a threshold of a signal-to-noise ratio that satisfies the request transmission rate and the condition that signal detection can be performed without the iteration process based on the BICM-ID. Then, the connection request process unit 222b compares the calculated signal-to-noise ratio to the threshold, and thereby performs the determination.

When the signal detection can be performed without the iteration process based on the BICM-ID, the reception device state information generation unit 211 generates reception device state information that requests transmission of signals based on the gray mapping. Additionally, the connection request process unit 222b generates mapping information indicative of the gray mapping.

When the signal detection cannot be performed without the iteration process based on the BICM-ID, the connection request process unit 222b determines whether or not a delay time exceeds the allowable maximum delay time due to the iteration process based on the BICM-ID. The connection request process unit 222b previously registers, on the internal memory, a delay time obtained by simulations. Then, the connection request process unit 222b compares the delay time to the allowable maximum delay time, and thereby performs the determination.

When the delay time exceeds the allowable maximum delay time by performing the iteration process based on the BICM-ID, the reception device state information generation unit 211 generates reception device state information that requests transmission of signals based on the gray mapping. Additionally, the connection request process unit 222b generates mapping information indicative of the gray mapping.

When the delay time does not exceed the allowable maximum delay time even if the iteration process is performed based on the BICM-ID, the reception device state information generation unit 211 generates reception device state information that requests transmission of signals based on the set partitioning mapping. Additionally, the connection request process unit 222b generates mapping information indicative of the set partitioning mapping.

Thus, according to the second embodiment, the reception device 200b determines a signal detection method and a mapping method based on the request transmission rate and the allowable maximum delay time. Accordingly, signal detection based on the gray mapping is performed when a request transmission rate can be satisfied without performing the iteration process based on the BICM-ID, thereby preventing a delay of reception due to the iteration process. Further, signal detection based on the gray mapping is performed when a delay time exceeds the allowable maximum delay time due to execution of the iteration process based on the BICM-ID, thereby making it possible to keep the delay time equal to or less than the allowable maximum delay time.

The case where the reception device 200b selects a mapping method has been explained in the second embodiment. However, the second embodiment is not limited thereto. Instead, the transmission device 300 may select a mapping method based on the reception device state information and information concerning downlink channel quality and the like, which are fed back by the reception device 200b, and on an indicator indicating the amount of traffic, such as the size of unsent data, which the transmission device 300 has.

According to the second embodiment, the case where the reception device 200b determines a signal detection method and a mapping method based on a request transmission rate and an allowable delay time. However, the second embodiment is not limited thereto.

For example, when the reception device 200b is powered by a battery, the connection request process unit (remaining battery power determination unit) 222b determines whether or not there remains battery power required for the reception process based on the BICM-ID. For example, a threshold, which indicates that the remaining battery power is insufficient, is previously determined. Then, if the level of the remaining battery power is equal to or greater than the threshold, it is determined that the remaining battery power is sufficient. If the level of the remaining battery power is smaller than the threshold, it is determined that the remaining battery power is insufficient. When the connection request process unit 222b determines that the remaining battery power is insufficient, the reception state information unit 211 generates reception device state information that requests transmission of signals based on the gray mapping. Thus, a mapping method may be determined based on another state that indicates whether or not the reception device 200b can perform the signal detection process based on the BICM-ID, such as the remaining battery power.

(Third Embodiment)

Hereinafter, a third embodiment of the present invention is explained. The third embodiment is an example of a radio communication system that determines an optimal signal detection process based on an allowable maximum delay time.

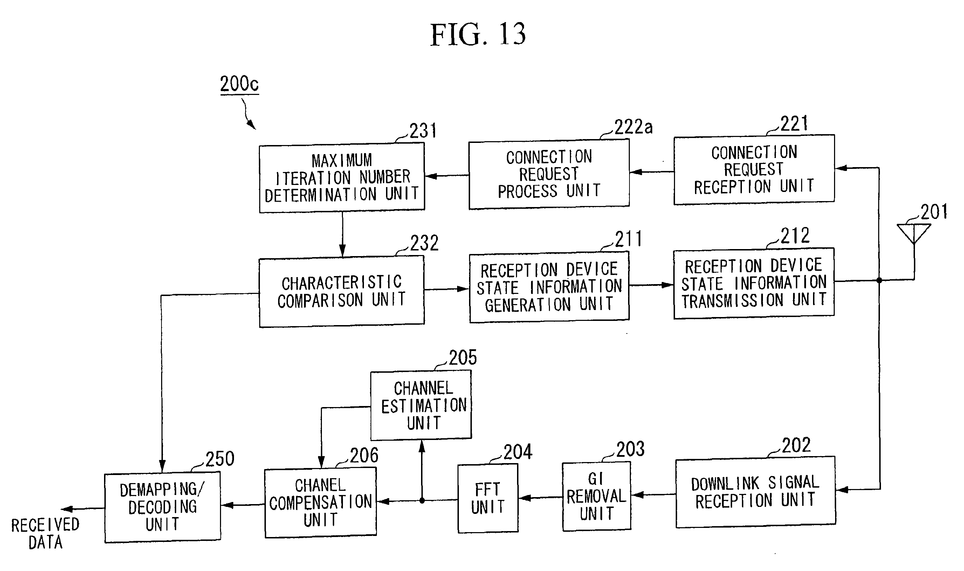

FIG. 13 is a schematic block diagram illustrating a configuration of a reception device according to the third embodiment of the present invention.

A reception device 200c of the third embodiment has the same configuration of the reception device 200a of the first embodiment except that a characteristic comparison unit 232 is newly provided. The other process units are the same as those included in the reception device 200a of the first embodiment, and therefore explanations are given using the same reference numerals. Since the transmission device 300 has the same configuration as that of the first embodiment, explanations are given using the same reference numerals.

Hereinafter, operations of the maximum iteration number determination unit 231 and the characteristic comparison unit 232 are explained.

The maximum iteration number determination unit 231 previously calculates and stores on internal memory, a time a required for one iteration process by the demapping/decoding unit 250, and a time b required for the processes by the GI removal unit 203, the FFT unit 204, the channel estimation unit 205, and the channel compensation unit 206.

Firstly, when the connection request reception unit 221 receives a connection request, and the connection request process unit 222a outputs a reception device state information generation command to the maximum iteration number determination unit 231, the maximum iteration number determination unit 231 calculates the maximum iteration number of times n from the maximum allowable delay time T. The maximum iteration number of times n can be calculated by calculating n satisfying the condition that $T < an + b$.

The characteristic comparison unit 232 obtains the maximum iteration number of times n output from the maximum iteration number determination unit 231. The characteristic comparison unit 232 compares an error rate when the downlink signal having been subjected to the set partitioning mapping is subjected to the repetition process n times to an error rate when the downlink signal having been subjected to the gray mapping is subjected to signal detection without using the BICM-ID. For example, based on simulations, the characteristic comparison unit 232 previously calculates and stores on the internal memory, an error rate when the BICM-ID corresponding to the signal-to-noise ratio is used, and an error rate when signal detection based on the gray mapping is performed. The characteristic comparison unit 232 calculates a signal-to-noise ratio from the connection request signal received form the transmission device 300, calculates, based on interpolation, an error rate corresponding to the signal-to-noise ratio from the internal memory, and then performs comparison.

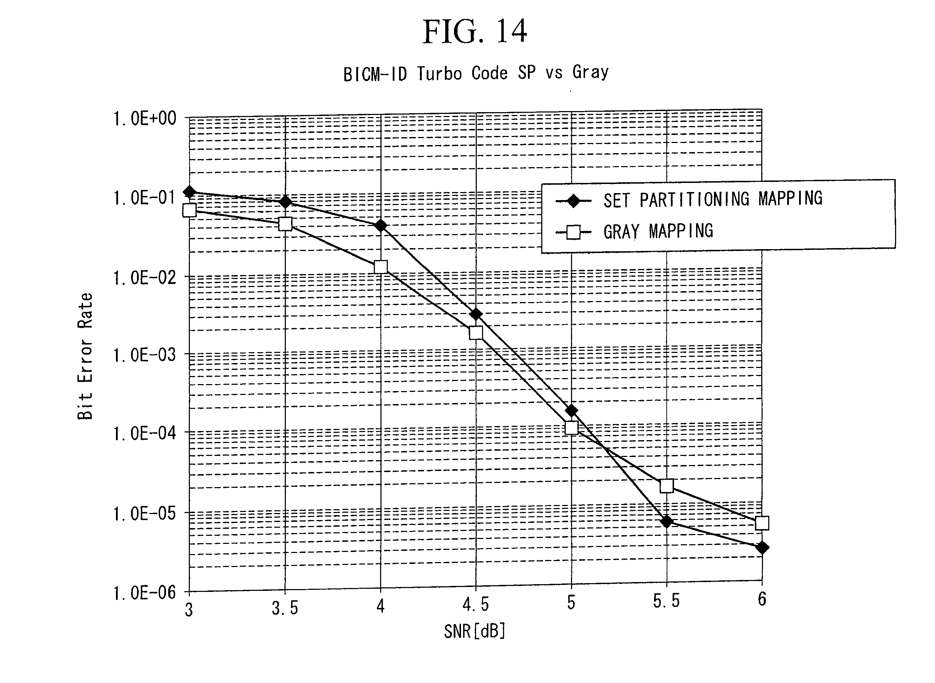

FIG. 14 is a graph illustrating an error rate of signal detection based on the BICM-ID and an error rate of signal detection based on the gray mapping.

Vertical and horizontal axes shown in FIG. 14 denote a bit error rate and signal-to-noise ratio, respectively. In the case of FIG. 14, for example, when the signal-to-noise ratio is 5.5 dB, the characteristics of the signal detection based on the BICM-ID is better than that of the signal detection based on the gray mapping. When the signal-to-noise ratio is 4 dB, the characteristics of the signal detection based on the gray mapping is better than that of the signal detection based on the BICM-ID.

The characteristic comparison unit 232 selects a signal detection process with the lower error rate, and outputs a reception state information generation command indicative of the selected signal detection process to the reception device state information generation unit 211. Additionally, the characteristic comparison unit 232 outputs mapping information corresponding to the selected signal detection process to the demapping/decoding unit 250.

Thus, according to the third embodiment, the reception device 200c calculates the maximum iteration number of times based on the allowable maximum delay time. Then, the reception device 200c compares the error rate characteristic when the iteration process based on BICM-ID is performed for the maximum iteration number of times to the error rate characteristic when the signal detection based on the gray mapping is performed. Thus, a signal detection process with better error rate characteristics can be performed while keeping a delay time being equal to or less than the allowable maximum delay time.

The case where the characteristic comparison unit 232 selects a signal detection method by calculating, from the internal memory, an error rate corresponding to the current signal-to-noise ratio based on interpolation, and then performing comparison has been explained in the third embodiment. However, the third embodiment is not limited thereto. For example, the characteristic comparison unit 232 previously registers, on the internal memory, a value of a signal-to-noise ratio at which the level relationship between an error rate of signal detection based on the BICM-ID and an error rate of signal detection based on the gray mapping becomes reversed. Then, the characteristic comparison unit 232 may compare a current signal-to-noise ratio to the signal-to-noise ratio stored in the internal memory, and thereby determine a signal detection method.

Additionally, the case where the reception device 200c selects a signal detection method has been explained in the third embodiment. However, the third embodiment is not limited thereto. Instead, the transmission device 300 may perform the aforementioned characteristic comparison using reception device state information and information concerning a downlink channel quality and the like, which are fed back by the reception device 200c. Further, the transmission device 300 may select a signal detection method based on the reception device state information and the information concerning the downlink channel quality and the like, and on an indicator indicating the amount of traffic, such as the size of unsent data, which the transmission device 300 has.

Description of Reference Numerals

200a: reception device
201: antenna
202: downlink signal reception unit
203: GI removal unit
204: FFT unit
205: channel estimation unit
206: channel compensation unit
211: reception device state information generation unit
212: reception state information transmission unit
221: connection information reception unit
222a: connection request unit
250: demapping/decoding unit
251: demapping unit
252: deinterleaving unit
253: decoding unit
254: interleaving unit
255: hard decision unit
256, 257: subtraction unit
300: transmission device
301: antenna
302: downlink transmission unit
303: GI insertion unit
304: IFFT unit
305: frame composition unit
306: mapping control unit
311: reception device state information reception unit
321: connection request transmission unit
330: downlink transmission data control unit
350: encoding/mapping unit
351: encoding unit
352: interleaving unit
353: mapping unit

**Claims**

1. A radio communication system comprising:

   a first communication device that wirelessly transmits a downlink signal; and
   at least one second communication device that receives the downlink signal transmitted by the first communication device, the second communication device comprising:

   a downlink signal reception unit that receives the downlink signal transmitted by the first communication device; and
   a reception device state information transmission unit that transmits reception device state information that indicates a modulation scheme and a channel encoding scheme, the second communication device being compatible with the modulation scheme, and

   the first communication device comprising:

   a reception device state information obtaining unit that obtains the reception device state information;
   a mapping control unit that selects, based on the modulation scheme indicated by the reception device state information, a mapping method of mapping between bits of the downlink signal to be transmitted to the second communication device and signal points, and outputs mapping information indicating the mapping method selected;
   an encoding unit that performs channel encoding on the downlink signal;
   a mapping unit that performs mapping on the downlink signal encoded, based on the mapping information; and
   a downlink signal transmission unit that transmits the downlink signal having been subjected to the mapping, based on the reception device state information.

2. The radio communication system according to claim 1, wherein
   the at least one second communication device is compatible with bit interleaved coded modulation with iterative decoding,
   the second communication device compatible with the bit interleaved coded modulation with iterative decoding comprises:

   a demapping unit that when post-decoding likelihood information of the downlink signal is input, performs demapping on the downlink signal based on the post-decoding likelihood information of the downlink signal and the modulation scheme with which the second communication device is compatible, the demapping unit performing demapping on the downlink signal based on the downlink signal and the modulation scheme with which the second communication device is compatible when post-decoding likelihood information of the downlink signal is not input, and the demapping unit outputting post-demapping likelihood information; and
   a decoding unit that performs decoding based on the post-demapping likelihood information of the downlink signal, and outputs post-decoding likelihood information of the encoded bits,

   the second communication device compatible with the bit interleaved coded modulation with iterative decoding iterates, for the downlink signal, demapping by the demapping unit and decoding by the decoding unit, and
   reception device state information of the second communication device compatible with the bit interleaved coded modulation with iterative decoding indicates that the second device is compatible with the bit interleaved coded modulation with iterative decoding.

3. The radio communication system according to claim 2, wherein
   the second communication device compatible with the bit interleaved coded modulation with iterative decoding comprises:

   a deinterleaving unit that performs deinterleaving on post-demapping likelihood information of the downlink signal; and
   an interleaving unit that performs interleaving on post-decoding likelihood information of the downlink signal.

4. The radio communication system according to any one of claims 1 to 3, wherein the mapping control unit of the first communication device selects any one of a gray mapping and a mapping method other than the gray mapping.

**5.** The radio communication system according to claim 4, wherein the mapping method other than the gray mapping comprises a set partitioning mapping.

**6.** The radio communication system according to any one of claims 1 to 5, wherein the mapping control unit of the first communication device selects the mapping method other than the gray mapping when the reception device state information indicating that the reception device is compatible with bit interleaved coded modulation with iterative decoding is received.

**7.** The radio communication system according to any one of claims 2 to 6, wherein the reception device state information of the second communication device compatible with the bit interleaved coded modulation with iterative decoding indicates that the second communication device is a LTE-A compatible terminal.

**8.** The radio communication system according to any one of claims 4 to 7, wherein the mapping control unit of the first communication device selects the gray mapping when the reception device state information is not input.

**9.** The radio communication system according to any one of claims 2 to 8, wherein
the second communication device compatible with the bit interleaved coded modulation with iterative decoding comprises:

a delay time calculation unit that calculates a delay time when demapping by the demapping unit and decoding by the decoding unit are repeatedly performed on the downlink signal having been subjected to mapping using a mapping method other than a gray mapping, and

when the delay time calculated exceeds an allowable maximum delay time previously determined, the reception device state information transmission unit of the second communication transmits the reception device state information that requests the downlink signal subjected to mapping using the gray mapping.

**10.** The radio communication system according to any one of claims 2 to 9, wherein
the second communication device compatible with the bit interleaved coded modulation with iterative decoding comprises:

a transmission rate calculation unit that calculates a transmission rate when demapping by the demapping unit and decoding by the decoding unit are performed one time on the downlink signal having been subjected to mapping using a gray mapping, and

when the transmission rate calculated satisfies a request transmission rate previously determined, the reception device state information transmission unit of the second communication transmits the reception device state information that requests the downlink signal subjected to mapping using the gray mapping.

**11.** The radio communication system according to any one of claims 2 to 10, wherein
the second communication device compatible with the bit interleaved coded modulation with iterative decoding is powered by a battery,
the second communication device compatible with the bit interleaved coded modulation with iterative decoding comprises:

a remaining battery power determination unit that determines whether or not a remaining amount of the battery is sufficient enough to repeatedly perform demapping by the demapping unit and decoding by the decoding unit,

when it is determined that the remaining amount of the second communication device is insufficient, the reception device state information transmission unit of the second communication transmits the reception device state information that requests the downlink signal subjected to mapping using the gray mapping.

**12.** The radio communication system according to any one of claims 2 to 8, wherein
the second communication device compatible with the bit interleaved coded modulation with iterative decoding comprises:

an iteration number calculation unit that calculates the maximum iteration number of times for which demapping by the demapping unit and decoding by the decoding unit are repeatedly performed on the downlink signal, the maximum iteration number of times satisfying an allowable maximum delay time previously determined; and
a process characteristic comparison unit that calculates and compares an error rate when demapping by the demapping unit and decoding by the decoding unit are performed the maximum iteration number of times on the downlink signal subjected to mapping using a mapping method in which adjacent signal points differ from each other by two bits or more, the downlink signal being transmitted by the first communication device, and an error rate when demapping by the demapping unit and decoding by the decoding unit are performed one time on the downlink signal subjected to mapping using gray mapping, the downlink signal being transmitted by the first communication device, and

the reception device state information transmission unit of the second communication transmits the reception device state information that requests the downlink signal subjected to mapping using the mapping method with the lower error rate.

13. A radio communication method for a first communication device and a second communication device to communicate with each other,
wherein the first communication device
is provided with a plurality of mapping methods of assigning a plurality of encoded bits to a modulation symbol of transmission data modulated based on multi-level modulation, and
transmits the plurality of encoded bits assigned based on one of the plurality of mapping methods that is selected based on a request from the second communication device.

14. The radio communication method according to claim 13, wherein the request from the second communication device indicates which demapping method compatible with the plurality of mapping methods the second communication device is provided with.

15. The radio communication method according to claim 13, wherein the request from the second communication device indicates a quality of service of a channel from the first communication device to the second communication device.

16. The radio communication method according to claim 13, wherein the request from the second communication device indicates an allowable maximum delay time.

17. A communication device that receives encoded bits assigned by one of a plurality of mapping methods of assigning a plurality of encoded bits to a modulation symbol of transmission data modulated based on multi-level modulation, the communication device comprising:

a connection request process unit that determines a mapping method based on information indicating which demapping method compatible with the plurality of mapping methods is provided.

18. The communication device according to claim 17, wherein the connection request process unit determines a mapping method based on information concerning a quality of service of a received signal.

19. The communication device according to claim 17, wherein the connection request process unit determines a mapping method based on an allowable maximum delay time.

# FIG. 1

200a

| 222a | | 221 |
|---|---|---|
| CONNECTION REQUEST PROCESS UNIT | ← | CONNECTION REQUEST RECEPTION UNIT |

201

| 211 | | 212 |
|---|---|---|
| RECEPTION DEVICE STATE INFORMATION GENERATION UNIT | → | RECEPTION DEVICE STATE INFORMATION TRANSMISSION UNIT |

205

CHANNEL ESTIMATION UNIT

| 250 | 206 | 204 | 203 | 202 |
|---|---|---|---|---|
| DEMAPPING/ DECODING UNIT | CHANNEL COMPENSATION UNIT | FFT UNIT | GI REMOVAL UNIT | DOWNLINK SIGNAL RECEPTION UNIT |

RECEPTION DATA

EP 2 326 056 A1

EP 2 326 056 A1

# FIG. 2

250

RECEPTION SIGNAL $r_t$ → DEMAPPING UNIT 251 → $L_m^{apo}(v_t)$ → 257 (+) $L_m^{ex}(v_t)$ → DEINTERLEAVING UNIT 252 → $L_c^{apr}(c)$ → DECODING UNIT 253 → $L_c^{apo}(b)$ → HARD DECISION UNIT 255 → RECEPTION DATA

257 (−) ← $L_m^{apr}(v_t)$ ← INTERLEAVING UNIT 254 ← $L_c^{ex}(c)$ ← 256 (−)(+) $L_c^{apo}(c)$

256

# FIG. 3

300

EP 2 326 056 A1

301

330

DOWNLINK
TRANSMISSION DATA
CONTROL UNIT

321

CONNECTION REQUEST
TRANSMISSION UNIT

311

RECEPTION DEVICE
STATE INFORMATION
RECEPTION UNIT

306

MAPPING
CONTROL
UNIT

302

DOWNLINK SIGNAL
TRANSMISSION
UNIT

303

GI
INSERTION
UNIT

304

IFFT
UNIT

305

FRAME
COMPOSITION
UNIT

350

ENCODING/
MAPPING
UNIT

22

# FIG. 4

EP 2 326 056 A1

_350_

MAPPING CONTROL INFORMATION

TRANSMISSION DATA $\xrightarrow{\quad u_t \quad}$ | ENCODING UNIT | 351 $\xrightarrow{\quad c_t \quad}$ | INTERLEAVING UNIT | 352 $\xrightarrow{\quad v_t \quad}$ | MAPPING UNIT | 353 $\longrightarrow$ MODULATION SYMBOL $s_t$

# FIG. 5

```
                    ┌─────────┐
                    │  START  │
                    └────┬────┘
                         │                                    ┌─(1)
                         ▼         ╭S1                         ▼          ╭S8
           ┌───────────────────────────┐          ┌───────────────────────────┐
           │ ITERATION NUMBER OF TIMES │          │      SUBTRACT RESULT OF    │
           │           L=0             │          │     DEINTERLEAVING FROM    │
           └─────────────┬─────────────┘          │     RESULT OF DECODING     │
                         ▼         ╭S2             └─────────────┬─────────────┘
           ┌───────────────────────────┐   ╭(3)                 ▼          ╭S9
           │     DEMAPPING PROCESS     │          ┌───────────────────────────┐
           └─────────────┬─────────────┘          │    INTERLEAVING PROCESS   │
                         ▼         ╭S3             └─────────────┬─────────────┘
           ┌───────────────────────────┐                        ▼          ╭S10
           │   DEINTERLEAVING PROCESS  │          ┌───────────────────────────┐
           └─────────────┬─────────────┘          │     DEMAPPING PROCESS     │
                         ▼         ╭S4             └─────────────┬─────────────┘
           ┌───────────────────────────┐                        ▼          ╭S11
           │      DECODING PROCESS     │          ┌───────────────────────────┐
           └─────────────┬─────────────┘          │      SUBTRACT RESULT OF    │
                         ▼         ╭S5             │    INTERLEAVING FROM RESULT│
                    ◇─────────◇      YES           │        OF DEMAPPING        │
                   ◇  GRAY     ◇─────────┐         └─────────────┬─────────────┘
                    ◇ MAPPING?◇          │                      ▼
                     ◇───────◇           │                     (3)
                        │NO              │
                         ▼     ╭S6       │                     (2)
           ┌───────────────────────────┐│                      ▼          ╭S12
           │         L=L+1             ││         ┌───────────────────────────┐
           └─────────────┬─────────────┘│         │    HARD DECISION PROCESS  │
                         ▼     ╭S7       │         └─────────────┬─────────────┘
                    ◇─────────◇   YES    │                      ▼
                   ◇L=PREDETER-◇─────────┤                 ┌─────────┐
                   ◇MINED NUMBER◇        │                 │   END   │
                   ◇ OF TIMES  ◇         │                 └─────────┘
                     ◇───────◇           │
                        │NO              │
                         ▼               ▼
                       (1)             (2)
```

# FIG. 6

SET PARTITIONING MAPPING

# FIG. 7

GRAY MAPPING

# FIG. 8

MODIFIED SET PARTITIONING MAPPING

# FIG. 9

RANDOM MAPPING

# FIG. 10

MIXED MAPPING

# FIG. 11

250

MODULATED SYMBOL → $r_t$ → [251 DEMAPPING UNIT] → $L_m^{ex}(v_t)$ → [252 DEINTERLEAVING UNIT] → $L_c^{apr}(c_t)$ → [253 DECODING UNIT] → $L_c^{apo}(b)$ → [255 HARD DECISION UNIT] → DECODED DATA

[254 INTERLEAVING UNIT] ← $L_c^{ex}(c_t)$ (from DECODING UNIT); output $L_m^{apr}(v_t)$ → DEMAPPING UNIT

EP 2 326 056 A1

## FIG. 12

EP 2 326 056 A1

# FIG. 13

200c

| | | |
|---|---|---|
| MAXIMUM ITERATION NUMBER DETERMINATION UNIT 231 | CONNECTION REQUEST PROCESS UNIT 222a | CONNECTION REQUEST RECEPTION UNIT 221 |
| CHARACTERISTIC COMPARISON UNIT 232 | RECEPTION DEVICE STATE INFORMATION GENERATION UNIT 211 | RECEPTION DEVICE STATE INFORMATION TRANSMISSION UNIT 212 |

201

CHANNEL ESTIMATION UNIT 205

DEMAPPING/ DECODING UNIT 250

RECEIVED DATA

CHANEL COMPENSATION UNIT 206

FFT UNIT 204

GI REMOVAL UNIT 203

DOWNLINK SIGNAL RECEPTION UNIT 202

EP 2 326 056 A1

# FIG. 14

BICM-ID Turbo Code SP vs Gray

# FIG. 15

1100

FIG. 16

1200

1201

| 1217 | 1216 | 1215 | 1214 | 1213 | 1212 | 1211 |
|---|---|---|---|---|---|---|
| RADIO TRANSMISSION UNIT | GI INSERTION UNIT | IFFT UNIT | FRAME COMPOSITION UNIT | MAPPING UNIT | INTERLEAVING UNIT | ENCODING UNIT |

DOWNLINK TRANSMISSION DATA

# FIG. 17

SET PARTITIONING MAPPING

<div align="center">

**INTERNATIONAL SEARCH REPORT**

</div>

| | International application No. |
|---|---|
| | PCT/JP2009/004544 |

**A. CLASSIFICATION OF SUBJECT MATTER**
H04L27/36(2006.01)i, H04J11/00(2006.01)i, H04W8/22(2009.01)i, H04W28/18
(2009.01)i

According to International Patent Classification (IPC) or to both national classification and IPC

**B. FIELDS SEARCHED**

Minimum documentation searched (classification system followed by classification symbols)
H04L27/36, H04J11/00, H04W8/22, H04W28/18

Documentation searched other than minimum documentation to the extent that such documents are included in the fields searched
Jitsuyo Shinan Koho          1922–1996   Jitsuyo Shinan Toroku Koho   1996–2009
Kokai Jitsuyo Shinan Koho    1971–2009   Toroku Jitsuyo Shinan Koho   1994–2009

Electronic data base consulted during the international search (name of data base and, where practicable, search terms used)
IEEE

**C. DOCUMENTS CONSIDERED TO BE RELEVANT**

| Category* | Citation of document, with indication, where appropriate, of the relevant passages | Relevant to claim No. |
|---|---|---|
| X | JP 2007-27988 A  (Sanyo Electric Co., Ltd.), 01 February 2007 (01.02.2007), | 1,13-16, 17-19 |
| Y | fig. 2, 7, 8; paragraphs [0065] to [0123] (Family: none) | 2-12 |
| Y | JP 2008-199574 A  (Nippon Hoso Kyokai), 28 August 2008 (28.08.2008), fig. 10; paragraphs [0040] to [0049] (Family: none) | 2-12 |
| Y | JP 2-288752 A  (Toshiba Corp.), 28 November 1990 (28.11.1990), fig. 5, 6 & US 5168509 A | 4-12 |

☒ Further documents are listed in the continuation of Box C.      ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>07 October, 2009 (07.10.09) | Date of mailing of the international search report<br>20 October, 2009 (20.10.09) |
|---|---|
| Name and mailing address of the ISA/<br>Japanese Patent Office | Authorized officer |
| Facsimile No. | Telephone No. |

Form PCT/ISA/210 (second sheet) (April 2007)

**INTERNATIONAL SEARCH REPORT**

International application No.

PCT/JP2009/004544

C (Continuation).    DOCUMENTS CONSIDERED TO BE RELEVANT

| Category* | Citation of document, with indication, where appropriate, of the relevant passages | Relevant to claim No. |
|---|---|---|
| A | JP 2005-204276 A  (Toshiba Corp.),<br>28 July 2005 (28.07.2005),<br>fig. 1<br>& US 2005/0169391 A1    & GB 2410152 A | 1-19 |
| A | JP 2000-13356 A  (Advanced Digital Television Broadcasting Laboratory),<br>14 January 2000 (14.01.2000),<br>fig. 1<br>(Family: none) | 2 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008234891 A

**Non-patent literature cited in the description**

- **A. Chindapol ; J. Ritcey.** Design, analysis and performance evaluation for BICM-ID with square QAM constellations in Rayleigh fading channels. *IEEE Journal of selected areas in communications,* May 2001, vol. 19 (5